# EUROPÄISCHE PATENTSCHRIFT

(11) **EP 1 317 994 B1**
(45) Veröffentlichungstag und Bekanntmachung des Hinweises auf die Patenterteilung: **10.11.2004**
(21) Anmeldenummer: 02026440.4
(22) Anmeldetag: 27.11.2002
(51) Int. Cl.: B23Q 15/22, G01N 21/95, H01L 21/00, G03F 7/20

(54) **Positioniereinrichtung für Halbleiterobjekte**
Positioning device for semiconductor objects
Dispositif de positionnement pour objets semiconducteurs

(30) Priorität: 05.12.2001 DE 10160521
(43) Veröffentlichungstag der Anmeldung: 11.06.2003
(73) Patentinhaber: HSEB Heinze & Süllau Entwicklungsbüro Dresden GmbH, 01099 Dresden (DE)
(72) Erfinder: Heinze, Manfred, 01109 Dresden (DE); Raue, Hagen, 02625 Göda (DE); König, Joachim, 01728 Bannewitz (DE)
(74) Vertreter: Bertram, Helmut, Dipl.-Phys.

(56) Entgegenhaltungen:
- WO-A-01/96836
- DE-A- 19 947 174
- US-A- 5 096 291
- US-B1- 6 204 917

## Beschreibung

Die Erfindung betrifft eine Positioniereinrichtung gemäß dem Oberbegriff des Anspruchs 1 (siehe, z.B., DE-19947174-A), mit der ein Halbleiterobjekt, wie ein Halbleiterwafer oder ein Flat Panel gegenüber einer Bezugsebene unterschiedlich geneigt, umgedreht und eine Rotationsbewegung um eine senkrecht zur Oberfläche des Halbleiterobjektes gerichtete Achse ausgeführt werden kann.
Derartige Einrichtungen sind insbesondere zu Inspektionszwecken einsetzbar.

Bisher bekannte technische Lösungen arbeiteten auf der Basis eines in den Raumrichtungen verstellbaren Aufnahmeelementes für die zu inspizierenden Halbleiterobjekte und sind mit einer zur Halterung dienenden Vakuumsaugeinrichtung versehen. Das Aufnahmeelement hält das Halbleiterobjekt während des Inspektionsvorgangs und erlaubt durch seinen Aufbau die Rotationsbewegung mit unterschiedlicher Neigung zum Beleuchtungsstrahlengang bzw. zur Inspektionsrichtung.

Bei einem derartigen, beispielsweise aus der US 5 096 291 bekannten Positioniersystem wird eine Halterung verwendet, die zur Ausführung der Bewegungen gelenkig gelagert ist. Betätigungselemente in Form von Stößeln übertragen die Bewegungen an die Halterung von einem, in seiner Neigung verstellbaren Ring, der mit einer drehbaren Spindel konzentrisch gekoppelt ist. Von Nachteil ist die durch die Verwendung von Stößeln verursachte Einschränkung des Bewegungsbereiches für die Halterung.

Alle Lösungen, die mit einer Vakuumsaugeinrichtung arbeiten, besitzen den Nachteil, dass eine Rückseitenbetrachtung stark eingeschränkt oder gänzlich unmöglich ist.

Außerdem können sich bei der bisher üblichen Halterung über einen weitgehend flächigen Kontakt Migrationen in unerwünschter Weise störend auf die beabsichtigten Eigenschaften des Halbleiterobjektes auswirken. Im übrigen lassen es neuere technologische Anforderungen nur noch zu, das Halbleiterobjekt in einem eng begrenzten Randbereich mit Halteelementen in Kontakt zu bringen. Auch der gesamte Rückseitenbereich ist als Berührungsfläche ausgeschlossen.

Aufgabe der Erfindung ist es, den Durchsatz bei einer uneingeschränkten Vorder- und Rückseiten-Inspektion von Halbleiterobjekten sowie die dabei erforderliche Sicherheit zu erhöhen.

Gemäß der Erfindung wird die Aufgabe durch eine Positioniereinrichtung nach Anspruch 1 gelöst.

Dadurch wird ein sehr schnelles, sicheres Öffnen und Schließen des durch die Auflagen und die Andruckelemente gebildeten Klemmmechanismus mit hoher Sicherheit gewährleistet, wodurch sich die Zeit zum Wechseln der Halbleiterobjekte wesentlich verkürzt.

Die Bewegung eines Andruckelementes kann entweder auf einer Kreisbahn erfolgen oder sich aus zwei nacheinander ablaufenden Teilbewegungen zusammensetzen, von denen eine erste parallel zur Oberfläche des Halbleiterobjektes und eine zweite senkrecht zu dieser Oberfläche gerichtet ist.

Es ist von Vorteil, wenn jedes der Andruckelemente einen zentrierenden Andruckkegel und einen Bereich aus elastischem Material aufweist, wodurch federnde Eigenschaften hervorgerufen werden.

Auch die Auflagen können mit Zentrierkegeln versehen sein, deren Kegelform in einen sphärischen Auflagebereich übergeht. Ein unterhalb des sphärischen Auflagebereiches befindlicher Auffangbereich verhindert ein Durchrutschen oder eine Beschädigung des Halbleiterobjektes bei einer fehlerhaften Übergabe.

Besondere Vorteile des rahmenförmigen Objekthalters bestehen darin, dass am Halbleiterobjekt im Falle einer Inspektion keine störenden Beleuchtungsschatten oder Einblickhindernisse im interessierenden Bereich entstehen.

Das Halbleiterobjekt liegt an keiner Stelle flächig auf, sondern nur punktuell mit seinem abgeschrägten Rand auf den gewölbten Auflagen, die aus inertem Material bestehen und keinerlei Kratzspuren hinterlassen. Da die Klemmeinrichtungen in den Bereichen am Halbleiterobjekt angreifen, in denen keine Strukturierungen im Herstellungsprozess vorgesehen sind, ist das Objekt praktisch vollständig und von beiden Seiten einsehbar.

Die Erfindung soll nachstehend anhand der schematischen Zeichnung näher erläutert werden. Es zeigen:
- Fig. 1: ein schematisiertes Bewegungssystem einer erfindungsgemäßen Positioniereinrichtung
- Fig. 2: einen verkleideten Objekthalter für die Positioniereinrichtung in einer perspektivischen Darstellung von oben
- Fig. 3: die Anordnung eines Haltemechanismus innerhalb des Objekthalters und eines Sensorteiles zur Lagekontrolle des Halbleiterobjektes
- Fig. 4: die Halterung eines Halbleiterobjektes, betrachtet aus der Richtung des Freiraumes
- Fig. 5: ein Antriebssystem für einen Haltemechanismus
- Fig. 6: das teilweise unverkleidete Antriebssystem
- Fig. 7: Sensorenstrahlengänge zur Lagekontrolle des Halbleiterobjektes
- Fig. 8: ein Blockschaltbild zur elektrischen Steuerung der Haltemechanismen

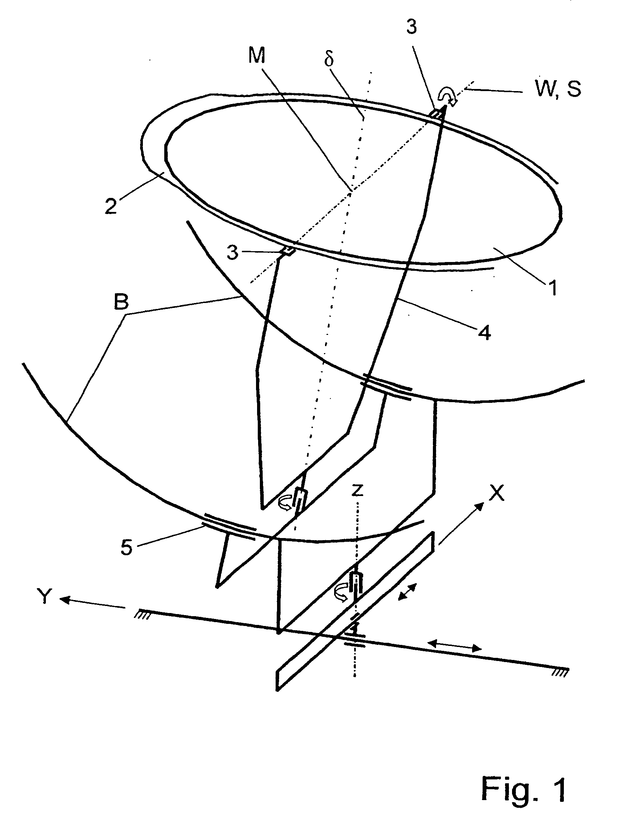

Das in Fig. 1 dargestellte Bewegungssystem ist dazu geeignet, ein Halbleiterobjekt 1, wie z. B. einen Halbleiterwafer oder ein Flat Panel im Raum zu positionieren.

Ein rahmenförmig ausgebildeter Objekthalter 2, der zur Vorder- und Rückseiteninspektion des Halbleiterobjektes 1 durch Drehung um eine Wendeachse W in einer Lagerung 3 eines gabelförmigen Rahmens 4 umgedreht werden kann, kann weiterhin eine Rotation um eine, durch das Zentrum M des Objekthalters 2 verlaufende und in der dargestellten Position der Mittelsenkrechten auf dem Halbleiterobjekt 1 entsprechenden Drehachse δ ausführen. Die Wendeachse W verläuft bei dem im vorliegenden Beispiel verwendeten Halbleiterwafer entlang seines Durchmessers. Die Drehachse δ kann entlang eines Kreisbogens B einer Bogenführung 5 gegen eine vertikale z-Achse eines Bezugssystems durch eine Schwenkbewegung mit unterschiedlichen Neigungswinkeln geneigt werden. Die dazugehörige Schwenkachse S verläuft ebenfalls durch das Zentrum M und ist parallel zu einer Justierebene X-Y gerichtet, die im Bezugssystem eine horizontale Lage einnimmt. Ein in der Justierebene X-Y verstellbarer und um die z-Achse drehbarer, nicht dargestellter X-Y-ϕ-Tisch kann dazu vorgesehen sein, die Bogenführung 5 zu tragen. In der in Fig. 1 gezeigten Position fällt die Schwenkachse S mit der Wendeachse W zusammen. Den Verstellungen um die Wendeachse W, die Drehachse δ und deren Neigungseinstellung zur vertikalen z-Achse und damit zur Justierebene X-Y können mit der vorliegenden Positioniereinrichtung außerdem eine Rotationsbewegung um die z-Achse und translatorische x-y-Bewegungen in der Justierebene X-Y überlagert werden.

Der zur Halterung des Halbleiterobjektes 1 dienende rahmenförmige Objekthalter 2 weist im vorliegenden Fall der Halterung eines Halbleiterwafers eine Ringstruktur auf, die einen Freiraum mit dem Zentrum M umschließt, der in seiner Größe und Form dem zu haltenden Halbleiterobjekt 1 angepasst ist. Ein offener Bereich 6 dient ebenso einem Zugriff mit einer kantengreifenden Handhabungseinrichtung bei der Zuführung und Entnahme des Halbleiterobjektes 1 wie eine partielle Erweiterung der Ringstruktur durch einen nach außen versetzten, zu dem offenen Bereich 6 gegenüberliegenden Ringabschnitt 7.

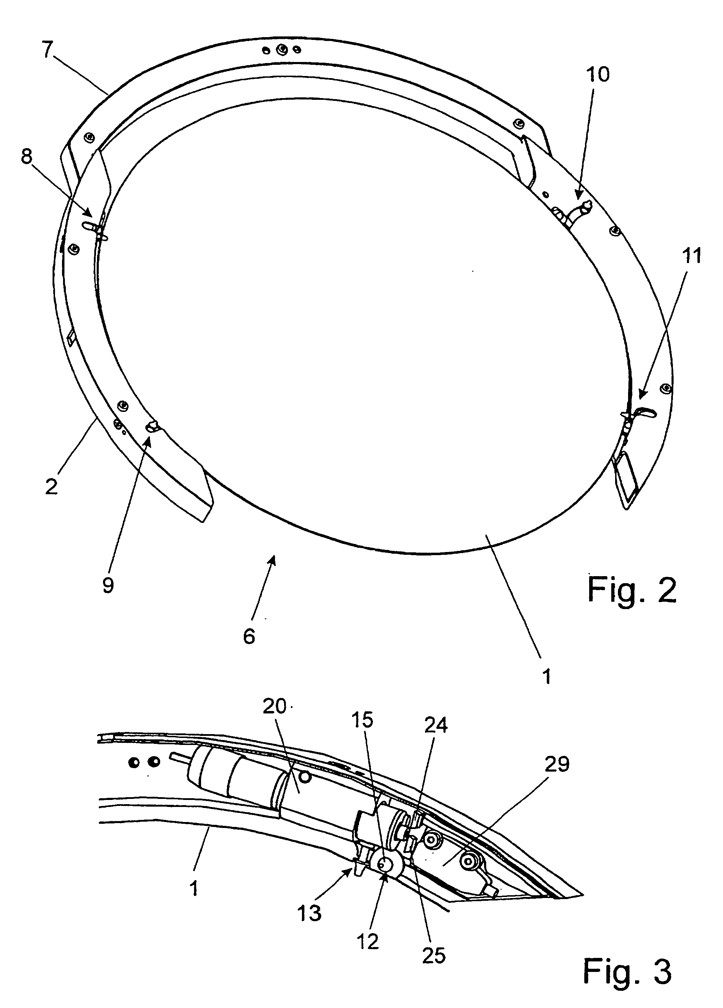

Vier Haltemechanismen 8, 9, 10 und 11 sind entlang der Ringstruktur verteilt und setzen sich jeweils aus einer Auflage 12 und einem Andruckelement 13 zusammen (Fig. 3). Die Auflagen 12, die aus rückwirkungsfreiem, minimal elastischen Material (z. B. PEEK) bestehen oder mit solchen mechanisch nachgiebigen Beschichtungen versehen sind, liegen zur Aufnahme des Halbleiterobjektes 1 in einer gemeinsamen Auflageebene AE und sind höhenjustierbar an einem gewinkelten Tragkörper 14 so angebracht, dass sie in den von dem Kreisring umschlossenen Freiraum ragen. Zentrierkegel 15 sorgen für eine Grobzentrierung des Halbleiterobjektes 1 bei dessen Zuführung. Ein Übergang der Kegelform des Zentrierkegels 15 in einen sphärischen Auflagebereich 16 gewährleistet eine punktuelle Auflage für den Kantenbereich des Halbleiterobjektes 1, der nicht für Strukturierungen im Herstellungsprozess vorgesehen ist. Unterhalb des sphärischen Auflagebereiches ist aus Sicherheitsgründen ein Auffangbereich in Form einer Fangrille 17 vorgesehen, die bei einer fehlerhaften Übergabe des Halbleiterobjektes 1 ein Durchrutschen oder eine Beschädigung verhindert.

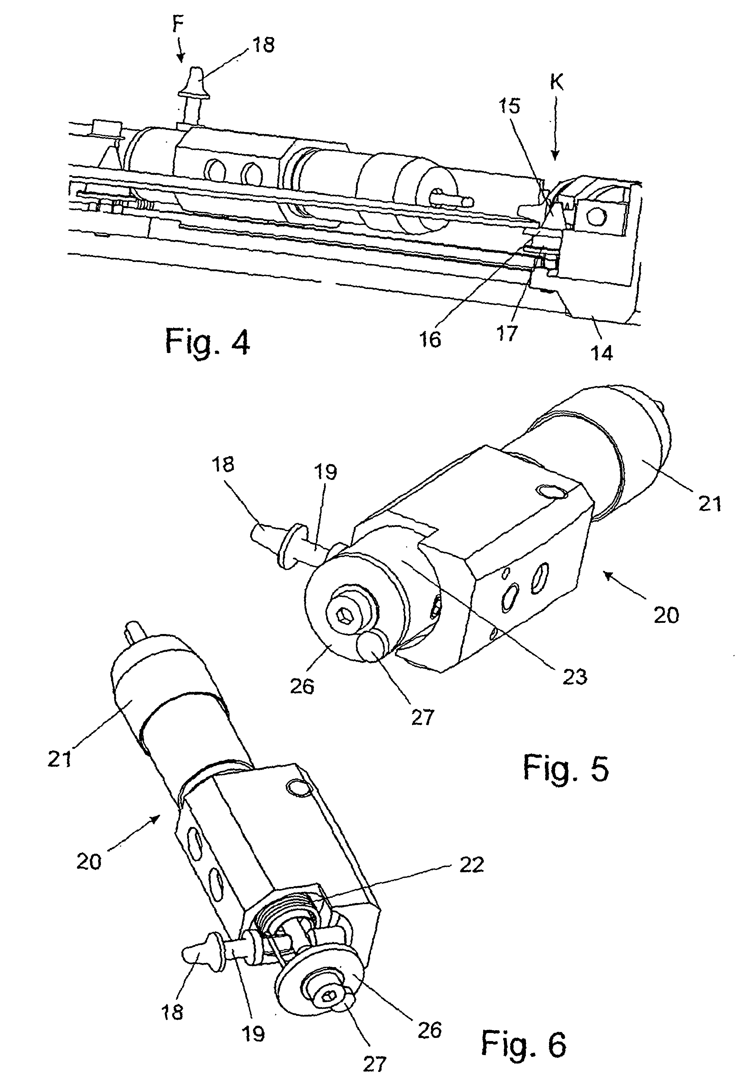

Vorteilhaft erfolgt die Auflage des Halbleiterobjektes 1 an einer von zwei zueinander geneigten Schrägen in dessen Kantenbereich. Die andere Schräge ist für die Anlage des Andruckelementes 13 vorgesehen, das ebenfalls im Material gleichartig ist zu dem der Auflage 12, so dass Beschädigungen an der Kante des Halbleiterobjektes 1 und deren Beschichtung vermieden werden. Das Andruckelement 13 besitzt in seinem vorderen Bereich einen als Übergangskegel mit einem übergehenden Kegelwinkel bzw. Konkavradius ausgebildeten Andruckkegel 18, so dass das bereits vorjustierte Halbleiterobjekt 1 beim Klemmvorgang vollständig zentriert wird (Fig. 4).
Ein sich an den Andruckkegel 18 anschließender federnder Bereich 19 wirkt sich vorteilhaft auf die Klemmeigenschaften der Haltemechanismen 8, 9, 10 und 11 aus. Mit dem gewissermaßen als "Klemmfinger" ausgebildeten Andruckelement 13 wird eine minimale Federwirkung beim Kantenandruck und eine Reduzierung von Rückwirkungskräften in seinen Antrieb 20 aufgrund des zwischengeschalteten federnden Bereiches 19 erreicht. Der Antrieb 20 ist ein Miniatur-Gleichstrommotor mit Untersetzungsgetriebe und für die Reinraumtauglichkeit in einer Partikelschutzkappe 21 gekapselt. Das Andruckelement 13 wird durch eine Schenkelfeder 22 (Fig. 6) mit einer zur Objekthalterung ausreichenden Minimalkraft in seiner Andruckposition gehalten, so dass auch bei Ausfall der Energieversorgung das Halbleiterobjekt 1 sicher geklemmt bleibt. Der Gleichstrommotor unterstützt die Feder beim Schließvorgang zum Herstellen der Klemmung und spannt diese beim Aufheben der Klemmung. Auch die Schenkelfeder 22 und deren Arbeitsraum ist partikelsicher durch ein Federgehäuse 23 gekapselt.

Zum schnellen Öffnen und Schließen der Haltemechanismen 8, 9, 10 und 11 wird das jeweilige Andruckelement 13 in einer Kombination aus vertikaler und horizontaler Bewegung oder, wie im vorliegenden Ausführungsbeispiel, auf einem Kreisbogen an den Kantenbereich des Halbleiterobjektes 1 herangeführt. Die Bewegung erfolgt zwischen zwei Endpositionen F und K in einer Ebene FE, die senkrecht zu der Auflageebene AE gerichtet ist, wobei das Halbleiterobjekt 1 in der Endposition K an den Auflagen 12 fixiert ist und in der anderen Endposition F, bei der die Andruckelemente 13 aus dem Freiraum herausgenommen sind, zur Handhabung freigegeben ist. Die Endpositionen F und K werden mit Hilfe von Hall-Sensoren 24 und 25 überwacht, zu deren Betätigung ein an einer Drehscheibe 26 befestigter Auslösemagnet 27 dient, der sich bei der Verstellung des Andruckelementes 13 mitdreht. Während der Hall-Sensor 25 die Klemmposition K detektiert, stellt der Hall-Sensor 24 den freigegebenen Zustand F für das Halbleiterobjekt 1 fest. Die Darstellung der Endpositionslagen der Andruckelemente 13 erfolgt in Fig. 4 lediglich zu anschaulichen Zwecken. Bei der tatsächlichen Funktionsausübung arbeiten die Andruckelemente 13 im Wesentlichen synchron.

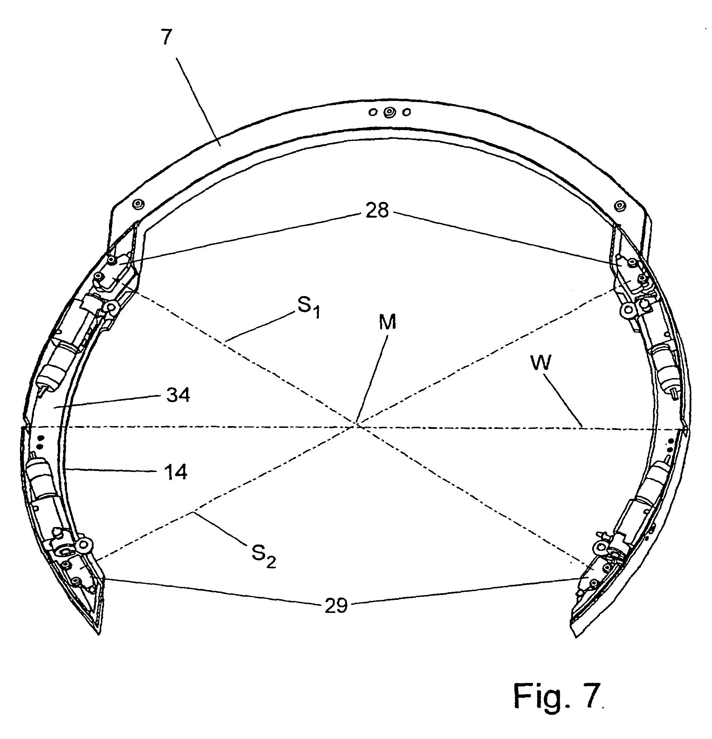

In Fig. 7 dargestellte Sensorstrahlengänge S1 und S2 zur Lagekontrolle des Halbleiterobjektes 1 sind durch eine zur Auflageebene AE parallel gerichtete Ebene SE in den Freiraum gelegt und kreuzen sich im Zentrum M des Objekthalters 2. Bereits mit einem Sensorsystem lassen sich Verkippungsfehler nachweisen, indem ein Sensorstrahlengang durch ein verkipptes Halbleiterobjekt 1 unterbrochen wird. Vorteilhaft ist das Sensorsystem jedoch in doppelter Ausführung vorgesehen, da hierdurch eine höhere Sicherheit bei der Fehlererkennung erreicht wird. Die Signale der beiden, in dem Objekthalter 2 untergebrachten Sensorsysteme 28 und 29 bilden durch eine "UND"-Verknüpfung ein gemeinsames Ausgangssignal, das den Ablagezustand des Halbleiterobjektes 1 charakterisiert.

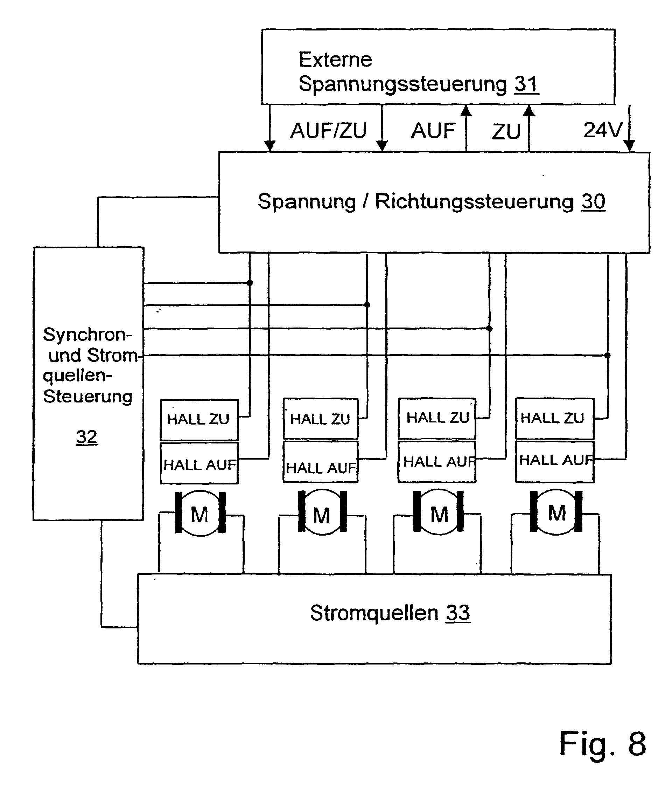

Anhand des Blockschaltbildes gemäß Fig. 8 soll die Steuerung der Gleichstrommotoren für die Andruckelemente 13 erläutert werden.

Über eine Spannungs- und Richtungssteuerung 30, die eingangsseitig sowohl mit den Hall-Sensoren 24 und 25 als auch mit einer externen digitalen Spannungssteuerung 31 verbunden ist, wird eine ein- und ausgangsseitig angeschlossene Synchron- und Stromquellensteuerung 32 angesteuert, die an Stromquellen 33 zur Stromversorgung der Antriebe 20 angeschlossen ist. Letztere sind nur in einer Klemmphase, in der das Halbleiterobjekt 1 durch die Andruckelemente 13 auf den Auflagen 12 fixiert ist, aktiv.

Das Herstellen der Klemmung erfolgt in vier Phasen
- Verlassen der Offenposition
- Schnelles Heranfahren des Andruckelementes 13 an die Klemmposition
- Synchronisationspause aller vier Andruckelemente 13 mit einem Zwangsstop der Antriebe 20, um ein gleichmäßiges Andrücken und optimales Zentrieren zu erreichen und schließlich einem
- Andrücken der Andruckelemente 13 an das Halbleiterobjekt 1.

Die Gleichstrommotoren der Antriebe 20 werden beim Lösen der Klemmung in drei Phasen betrieben:
- einem langsamen Entspannen des Andruckes
- einem schnellen Freifahren des Andruckelementes 13 und
- einem Halten der Schenkelfeder 18 in der Offenposition.

Um eine definierte, zusätzlich zu der Kraft der Schenkelfeder 22 wirkende Andruckkraft einstellen zu können, wird in der Andruckphase mit Konstantstrom gearbeitet, der für jedes Andruckelement 13 einstellbar ist und die nötige Andruckkraft erzeugt.
Die Andruckphase ausgenommen, werden die Motoren mit einer für jede Betriebsphase einstellbaren Konstantspannung angetrieben, die zusätzlich durch die externe digitale Spannungssteuerung 31 eingestellt werden kann.
Alle elektrischen Bauelemente und Verbindungen sind auf einer Leiterplatte 34 angeordnet, die in der Form an die Struktur des Objekthalters 2 angepasst ist.

## Patentansprüche

1. Positioniereinrichtung für Halbleiterobjekte mit einem rahmenförmigen Objekthalter zur Aufnahme eines Halbleiterobjektes, wobei der rahmenförmige Objekthalter (2) einen Freiraum für die Aufnahme des Halbleiterobjektes (1) umschließt sowie in einer Auflageebene befindliche Auflagen (12) und zwischen zwei Endpositionen verstellbare Andruckelemente (13) zur Halterung des Halbleiterobjektes (1) in dessen Randbereich enthält, **dadurch gekennzeichnet, dass** jedes Andruckelement (13) in dem Objekthalter (2) mit einem Antrieb (20) verbunden ist, der eine Bewegung des Andruckelementes (13) in einer Ebene erzeugt, die senkrecht zu der Auflageebene gerichtet ist, wobei das Halbleiterobjekt (1) in einer Endposition (K) an der Auflage fixiert ist und in der anderen Endposition (F), bei der das Andruckelement (13) aus dem Freiraum herausgenommen ist, zur Handhabung freigegeben ist.

2. Positioniereinrichtung nach Anspruch 1, **dadurch gekennzeichnet, dass** die Bewegung des Andruckelementes (13) auf einer Kreisbahn erfolgt.

3. Positioniereinrichtung nach Anspruch 2, **dadurch gekennzeichnet, dass** die Bewegung aus zwei nacheinander ablaufenden Teilbewegungen zusammengesetzt ist, von denen eine erste parallel zur Oberfläche des Halbleiterobjektes (1) und eine zweite senkrecht zu dieser Oberfläche gerichtet ist.

4. Positioniereinrichtung nach Anspruch 3, **dadurch gekennzeichnet, dass** jedes der Andruckelemente (13) einen zentrierenden Andruckkegel (18) mit federnden Eigenschaften aufweist.

5. Positioniereinrichtung nach Anspruch 4, **dadurch gekennzeichnet, dass** die federnden Eigenschaften durch einen Bereich (19) aus elastischem Material bestimmt sind.

6. Positioniereinrichtung nach einem der Ansprüche 2 bis 5, **dadurch gekennzeichnet, dass** jede der Auflagen (12) mit einem Zentrierkegel (15) versehen ist, dessen Kegelform in einen sphärischen Auflagebereich (16) für das Halbleiterobjekt (1) übergeht.

7. Positioniereinrichtung nach Anspruch 6, **dadurch gekennzeichnet, dass** dem sphärischen Auflagebereich (16) unterhalb ein Auffangbereich zur Verhinderung eines Durchrutschen oder einer Beschädigung des Halbleiterobjektes 1 bei einer fehlerhaften Übergabe benachbart ist.

8. Positioniereinrichtung nach einem der Ansprüche 2 bis 7, **dadurch gekennzeichnet, dass** jeder der Antriebe (20) mit einem Schaltelement (27) versehen ist, das in den Endpositionen Endlagensensoren (24, 25) betätigt.

9. Positioniereinrichtung nach einem der Ansprüche 2 bis 8, **dadurch gekennzeichnet, dass** der Objekthalter (2) mindestens einen Sensor (28, 29) zum Nachweis einer verkippungsfreien Lage des Halbleiterobjektes (1) enthält, dessen Sensorstrahlengang durch eine zu einer Auflageebene für das Halbleiterobjekt (1) parallel gerichteten Ebene gelegt ist.

10. Positioniereinrichtung nach einem der Ansprüche 2 bis 9, **dadurch gekennzeichnet, dass** der Objekthalter (2) als Ringstruktur ausgebildet ist, die einen offenen Bereich (6) für eine kantengreifende Handhabungseinrichtung zur Zuführung und Entnahme des Halbleiterobjektes (1) enthält und gegenüberliegend zu dem offenen Bereich durch einen versetzten Ringabschnitt (7) partiell erweitert ist.

## Claims

1. Positioning device for semiconductor objects comprising a frame-shaped object holder for receiving a semiconductor object, wherein said frame-shaped object holder (2) encloses a free space for reception of the semiconductor object (1) as well as includes supports (12) located in a supporting plane and pressing members (13) adjustable between two end positions for supporting the semiconductor object (1) in its edge region, **characterized in that** each pressing member (13) in the object holder (2) is connected to a drive (20) which generates a movement of the pressing member (13) within a plane that is perpendicular to the supporting plane, said semiconductor object (1) being fixed in an end position (K) on the support and being released for handling in the other end position (F) in which the pressing member (13) is removed from the free space.

2. The positioning device according to claim 1, **characterized in that** the movement of the pressing member (13) is effected on a circular path.

3. The positioning device according to claim 2, **characterized in that** said movement is composed of two sequentially performed partial movements, of which a first one is parallel to the surface of the semiconductor object (1) and a second one is perpendicular to said surface.

4. The positioning device according to claim 3, **characterized in that** each of the pressing members (13) comprises a centering pressing cone (18) having resilient properties.

5. The positioning device according to claim 4, **characterized in that** the resilient properties are determined by a region (19) of elastic material.

6. The positioning device according to any one of claims 2 to 5, **characterized in that** each of the supports (12) is provided with a centering cone (15), whose conical shape passes into a spherical support region (16) for the semiconductor object (1).

7. The positioning device according to claim 6, **characterized in that** a collecting region preventing the semiconductor object (1) from slipping through or from being damaged in an incorrect transfer is provided below the spherical support region (16) and in the vicinity thereof.

8. The positioning device according to any one of claims 2 to 7, **characterized in that** each of the drives (20) is provided with a switching element (27) which actuates limit sensors (24, 25) in the end positions.

9. The positioning device according to any one of claims 2 to 8, **characterized in that** the object holder (2) includes at least one sensor (28, 29) for detecting a tilt-free position of the semiconductor object (1), whose sensor beam path extends through a plane which is parallel to a supporting plane for the semiconductor object (1).

10. The positioning device according to any one of claims 2 to 9, **characterized in that** the object holder (2) is provided as an annular structure which includes an open region (6) for an edge-gripping handling device to supply and remove the semiconductor object (1) and which is partially extended by an offset annular portion (7) opposite said open region.

## Revendications

1. Dispositif de positionnement pour des objets semi-conducteurs comportant un support d'objet en forme de cadre destiné à recevoir un objet semi-conducteur, ledit support d'objet (2) en forme de cadre entourant un espace libre destiné à recevoir ledit objet semi-conducteur (1) et comportant des appuis (12) disposés dans un plan d'appui et des membres de pression (13) qui sont réglables entre deux positions extrêmes pour supporter l'objet semi-conducteur (1) dans sa zone marginale, **caractérisé en ce que** chaque membre de pression (13) dans le support d'objet (2) est relié à une commande (20) mettant en mouvement le membre de pression (13) dans un plan qui est perpendiculaire audit plan de support, ledit objet semi-conducteur (1) étant fixé dans une position extrême (K) sur ledit support et étant libéré afin d'être manipulé dans l'autre position extrême (F) dans laquelle ledit membre de pression (13) est enlevé de l'espace libre.

2. Dispositif de positionnement selon la revendication 1, **caractérisé en ce que** le mouvement du membre de pression (13) s'effectue sur une trajectoire circulaire.

3. Dispositif de positionnement selon la revendication 2, **caractérisé en ce que** ledit mouvement est composé de deux mouvements partiels successifs, un premier d'entre eux étant parallèle à la surface de l'objet semi-conducteur (1) et un second d'entre eux étant perpendiculaire à ladite surface.

4. Dispositif de positionnement selon la revendication 3, **caractérisé en ce que** chaque membre de pression (13) comprend un cône centrant de pression (18) présentant des propriétés d'élasticité.

5. Dispositif de positionnement selon la revendication 4, **caractérisé en ce que** lesdites propriétés d'élasticité sont déterminées par une zone (19) de matériel élastique.

6. Dispositif de positionnement selon l'une quelconque des revendications 2 à 5, **caractérisé en ce que** chaque support (12) est muni d'un cône de centrage (15), don't la forme conique passe à une zone sphérique de support (16) pour l'objet semi-conducteur (1).

7. Dispositif de positionnement selon la revendication 6, **caractérisé en ce qu'**une zone d'interception empêchant tout glissement ou endommagement de l'objet semi-conducteur 1 par un transfert incorrect est prévue au-dessous de ladite zone sphérique de support (16) et près de celle-ci.

8. Dispositif de positionnement selon l'une quelconque des revendications 2 à 7, **caractérisé en ce que** chaque commande (20) est munie d'un élément de circuit (27) qui commande des détecteurs de fin de course (24, 25) dans les positions extrêmes.

9. Dispositif de positionnement selon l'une quelconque des revendications 2 à 8, **caractérisé en ce que** le support d'objet (2) comprend au moins un détecteur (28, 29) destiné à détecter une position sans basculement de l'objet semi-conducteur (1), la trajectoire du rayon du détecteur traversant un plan qui est orienté parallèlement audit plan de support pour l'objet semi-conducteur (1).

10. Dispositif de positionnement selon l'une quelconque des revendications 2 à 9, **caractérisé en ce que** le support d'objet (2) est en forme d'une structure annulaire qui comporte une zone ouverte (6) pour un dispositif de manipulation avec grippage des bords, destiné à amener et enlever l'objet semi-conducteur (1) et qui est partiellement étendue par une section annulaire (7) décalée, qui se trouve en face de ladite zone ouverte.
